# EUROPEAN PATENT SPECIFICATION

(11) **EP 2 784 811 B1**
(45) Date of publication and mention of the grant of the patent: **20.09.2017**
(21) Application number: 14161555.9
(22) Date of filing: 25.03.2014
(51) Int. Cl.: H01L 23/427, H01L 23/34, F28D 15/02

(54) **Heat pipe sink with heating unit**
Wärmerohrsenke mit Heizeinheit
Collecteur de caloduc avec unité de chauffage

(30) Priority: 26.03.2013 US 201361805198 P; 07.03.2014 US 201414200824
(43) Date of publication of application: 01.10.2014
(73) Proprietor: GE Energy Power Conversion Technology Ltd, Rugby Warwickshire CV21 1BU (GB)
(72) Inventor: Opila, Daniel Francis, Pittsburgh PA Pennsylvania 15238-2808 (US); Fatschel, Stephan, Seven Fields PA Pennsylvania 16046 (US)
(74) Representative: Serjeants LLP

(56) References cited:
- WO-A1-00/57471
- JP-A- S5 623 764
- JP-A- H06 276 742
- JP-A- S60 185 038
- US-A1- 2010 051 254

## Description

### BACKGROUND OF THE INVENTION

### 1. Field of the Invention

The present invention pertains to heat sinks and, in particular, to heat sink devices having a plurality of heat pipes.

### 2. Description of the Related Art

Electrical semiconductor devices such as large scale integrated circuits, voltage regulators, current switching devices, high speed or high current circuits, and other similar devices, generate an amount of heat that can be detrimental to their operation. Thus, it is desirable to cool the semiconductor device sufficiently to maintain the operating temperature of the semiconductor device at or below a predetermined temperature.

Generally, to cool semiconductor devices, the heat generated by the semiconductor device is transferred away from the device and dissipated. A number of techniques are used to transfer and dissipate the heat from semiconductor devices. As an example, heat pipes have been used to move heat away from semiconductor devices and fins have been used with the heat pipes to dissipate the transferred heat to the air.

Heat pipes are enclosed pipes that transfer heat through the evaporation and condensation of a fluid contained in the heat pipe. More specifically, a typical heat pipe includes an evaporator section which is located near a heat source (i.e. the semiconductor device) and a condenser section which is located away from the heat source. The heat from the heat source causes fluid located in the evaporator section to evaporate. The vapor then moves to the condenser section, thus transferring heat generated by the heat source to the condenser section.

The condenser section of a heat pipe is often constructed to be in thermal contact with a series of metallic fins. The heat of the vapor in the condenser section is transferred into the fins where the large surface area of the fins aids in dissipating the heat into the air. Heat sinks have also used a blower to blow air over the fins to further aid the dissipation process. As the heat of the vapor is dissipated, the vapor cools off and condenses. The condensed fluid is then transferred back to the evaporator section to be heated up again. The cycle of evaporation and condensation continues, thus transferring and dissipating the heat generated by the heat source, and thereby cooling the heat source. However, the use of heat pipes with heat sinks has not been without difficulty.

In cold temperature environments, the liquid in the heat pipes, and in particular, in the condenser sections of the heat pipes, can freeze. When the liquid freezes in the condenser sections of the heat pipes, the evaporator sections of the heat pipes are no longer able to evaporate liquid and thus, the heat pipes become unusable until the frozen liquid in the condenser sections of the heat pipes is thawed. Liquids with a wide operating range (e.g., a lower freezing temperature) have been used in order to prevent the liquid from freezing in the heat pipes while sacrificing performance of the heat pipes.

Additionally, when operating in cold temperature environments, fully passive heat pipes can expose a heat source to wide range of temperatures since the heat pipes are not controllable. Exposing the heat source to a wide temperature swing can damage the heat source.

Thus, there is a need for an improved heat sink which uses heat pipes for use in cold temperature environments. JP S60-185038 discloses a heat pipe with an electrical heater fitted to an inner pipe.

### SUMMARY OF THE INVENTION

In one embodiment, a heat sink is provided. The heat sink comprises: a cold plate having a first surface adapted to thermally couple to a heat source; a plurality of heat pipes, each of the heat pipes having an evaporator section thermally coupled to the cold plate and a condenser section coupled to the evaporator section; a plurality of fins thermally coupled to the condenser sections of the plurality of heat pipes; a heating unit adapted to heat condenser sections of only a subset of the plurality of heat pipes and including a plurality of heating devices; and a control unit electrically connected to the plurality of heating devices and adapted to selectively provide power to the heating devices to heat the heating devices to thereby heat the subset of the plurality of heat pipes. Each of the plurality of heating devices is attached to a respective one of the fins nearby one of the heat pipes of the subset of the plurality of heat pipes. The heating unit can further comprise a plurality of second heating devices. Each of the plurality of second heating devices can be attached to a respective one of the fins nearby a second one of the heat pipes of the subset of the plurality of heat pipes. The heat sink can further comprise at least one temperature sensor adapted to sense at least one of a temperature of the heat source, a temperature of the condenser sections of the plurality of heat pipes, and an ambient temperature. The control unit controls the heating unit to heat the subset of the plurality of heat pipes based on at least one of the temperature of the heat source, the temperature of the condenser sections of the plurality of heat pipes, and the ambient temperature. The control unit can determine an amount of heat to apply to the subset of the plurality of heat pipes and controls the amount of heat by controlling at least one of a number of heat pipes heat is applied to, a duration in which power is applied, and an amount of power which is applied. The plurality of fins can each include at least one perforation which reduces an amount the plurality of fins dissipates heat of a selected one or more of the heat pipes of the plurality of heat pipes with respect to the remaining heat pipes of the plurality of heat pipes. In one embodiment, a method of heating heat pipes is provided. The method comprises: providing a cold plate having a first surface adapted to thermally couple to a heat source; providing a plurality of heat pipes, each of the heat pipes having an evaporator section thermally coupled to the cold plate and a condenser section coupled to the evaporator section; providing a plurality of fins thermally coupled to the condenser sections of the plurality of heat pipes; providing a plurality of heating devices; and providing power to the heating devices to heat the heating devices thereby heating condenser sections of only a subset of the plurality of heat pipes. Each of the plurality of heating devices is attached to a respective one of the fins nearby one of the heat pipes of the subset of the plurality of heat pipes.

### BRIEF DESCRIPTION OF THE DRAWINGS

FIG. 1 is an isometric view of a heat sink;
FIG. 2 is a side view of the heat sink shown in FIG. 1;
FIG. 3 is an end view of the heat sink shown in FIG. 1;
FIG. 4 is a side view of a heat pipe used in the heat sink shown in FIG. 1;
FIGS. 5 and 6 are isometric views of arrangements of heat sinks;
FIG. 7 is a side view of a system including a heat sink that does not form part of the inventive concept;
FIG. 8A and 8B are side views of heat sinks including a heating unit that does not form part of the inventive concept;
FIG. 9A and 9B are side views of heat sinks including a heating unit in accordance with the inventive concept;
FIG. 10 is a side view of a heat sink including a heating unit that does not form part of the inventive concept;
FIG. 11 is a side view of a heat sink including a tubular heater that does not form part of the inventive concept; and
FIG. 12 is an isometric view of a heat sink including perforations.

### DETAILED DESCRIPTION OF EXEMPLARY EMBODIMENTS

As used herein, the singular form of "a", "an", and "the" include plural references unless the context clearly dictates otherwise. As used herein, the statement that two or more parts or components are "coupled" shall mean that the parts are joined or operate together either directly or indirectly, i.e., through one or more intermediate parts or components, so long as a link occurs. As used herein, "directly coupled" means that two elements are directly in contact with each other. As used herein, "fixedly coupled" or "fixed" means that two components are coupled so as to move as one while maintaining a constant orientation relative to each other. As employed herein, the term "number" shall mean one or an integer greater than one (i.e., a plurality).

Directional phrases used herein, such as, for example and without limitation, top, bottom, left, right, upper, lower, front, back, and derivatives thereof, relate to the orientation of the elements shown in the drawings and are not limiting upon the claims unless expressly recited therein.

As used herein, the term "heating a heat pipe" and similar terms such as "heating a condenser section of the heat pipe" shall mean that heat is provided to the heat pipe in at least an amount sufficient to maintain a working fluid included in the heat pipe in liquid form when in would otherwise freeze or, in the case that the working fluid is frozen, to thaw the working fluid. The heat may be provided directly or indirectly to the heat pipe, i.e., through one or more intermediate parts or components.

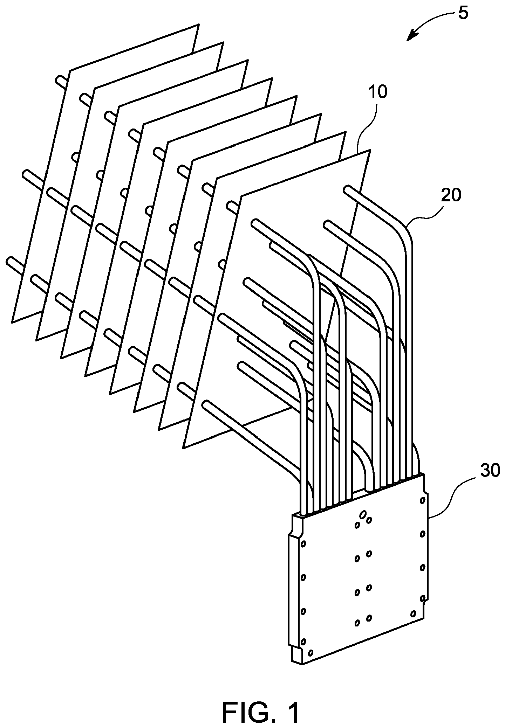

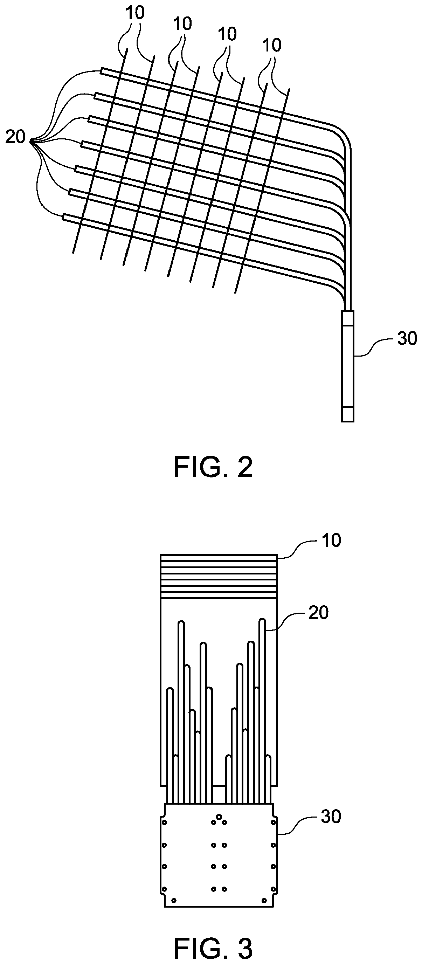

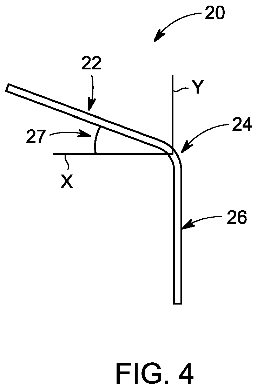

FIG. 1 is an isometric schematic of a heat sink 5. FIGS. 2 and 3 are side view and end view schematics, respectively, of the heat sink 5 illustrated in FIG. 1. FIG. 4 is a side view schematic of an exemplary heat pipe 20 which is adapted for use in the heat sink 5 illustrated in FIGS. 1-3.

Referring to FIGS. 1-3, the heat sink 5 includes a plurality of fins 10, a plurality of heat pipes 20, and at least one cold plate 30. The heat pipes 20 each include an evaporator section 26, a bend section 24, and a condenser section 22 (see FIG. 4). As shown in FIGS. 1-3, the evaporator section 26 is arranged substantially vertically and connected to the cold plate 30. The heat pipes 20 also include the condenser section 22 which is inclined with respect to a horizontal plane and extends through a plurality of fins 10. The evaporator section 26 and the condenser section 22 of each heat pipe 20 are connected by a single straight bend section 24.

The evaporator section 26 and the condenser section 22 are each substantially straight pieces of piping. The evaporator sections 26 of the heat pipes 20 extend in parallel with each other and the condenser sections 22 of the heat pipes 20 extend in parallel with each other. The bend section 24 includes a piece of piping having a single straight bend. As employed herein, the term "single straight bend" means a single bend with a substantially constant radius and without a substantial twist or skew. The geometry of each heat pipe 20 has minimal complexity.

A plurality of heat pipes 20 are thermally coupled to the cold plate 30. Although FIGS. 1-3 show sixteen heat pipes 20 thermally coupled to the cold plate 30, the present invention is not limited thereto. It is contemplated that any number of heat pipes 20 greater than two can be thermally coupled to the cold plate 30 while remaining within the scope of the invention.

The vertical evaporator sections 26 of adjacent heat pipes 20 have different lengths. As such, the condenser sections 22 of adjacent heat pipes 20 are spaced apart from each other and extend through different areas of the fins 10. As illustrated in FIG. 1, the heat pipes 20 are spread across the area of the fins 10. Spreading out the locations where the heat pipes 20 extend through the fins 10 increases the efficiency of the fins 10 in dissipating the heat of the heat pipes 20 as compared to a configuration wherein the heat pipes 20 extend through the same area of the fins 10.

The condenser section 22 of the heat pipe 20 is inclined with respect to a horizontal plane by an angle 27 (see FIG. 4). For example and without limitation, the angle 27 may be within a range of about 5-40 degrees, or preferably about 5-20 degrees.

As illustrated in FIGS. 1-3, the evaporator section 26 of the heat pipes 20 and the cold plate 30 are arranged substantially vertically. However, it will be appreciated that the condenser section 22 of the heat pipes 20 and the cold plate 30 may also be tilted with respect to a vertical axis.

As illustrated in FIGS. 1-3, the heat pipes 20 are inserted into an upper surface of the cold plate 30. However, it is contemplated that the heat pipes 20 may be connected to the cold plate 30 in any suitable manner which thermally couples them while remaining within the scope of the invention. The cold plate 30 may include an interior chamber (e.g. a vapor chamber) and the heat pipes 20 may be coupled to an upper surface of the cold plate 30 and be fluidly connected with the interior chamber of the cold plate 30. Additionally, it is contemplated that the heat pipes 20 may be attached to the cold plate 30 by, for example and without limitation, welding, soldering, or by using a suitable thermally conductive adhesive.

The fins 10 are spaced apart from each other. The number, spacing, size, and/or thickness of the fins 10 can be varied. For example, the number, spacing, size, and/or thickness of the fins 10 can be optimized based on an expected thermal loading of different areas of the fins 10.

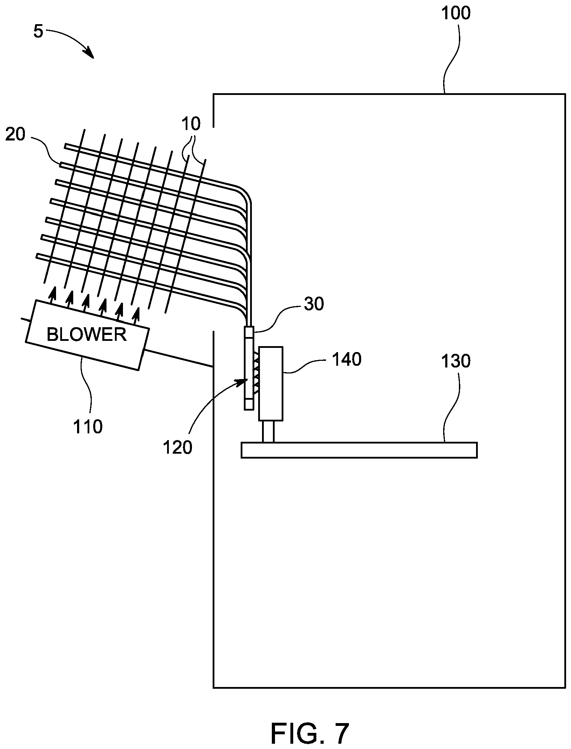

The cold plate 30 is adapted to thermally couple with a heat source (see FIG. 7). The cold plate 30 may be thermally coupled with the heat source in any suitable manner such as, without limitation, by a thermally conductive adhesive.

FIG. 4 is a side view schematic of an exemplary heat pipe. The heat pipe 20 shown in FIG. 4 is readily adapted for use in the heat sinks 5 shown in FIGS. 1-3. For example, the heat pipes 20 shown in FIGS. 1-3 are similar except that lengths of the evaporator sections 26 of the heat pipes 20 are varied. When employed for use in the heat sinks 5 shown in FIGS. 1-3, the evaporator sections 26 of the heat pipes 20 are coupled with the cold plate 30. For example, the evaporator sections 26 of the heat pipes 20 can be inserted into the cold plate 30.

The heat pipe 20 operates to transfer heat from the evaporator section 26 to the condenser section 22 through the evaporation and condensation of a liquid included in the heat pipe 20. More particularly, when the evaporator section 26 of the heat pipe 20 is heated, the liquid evaporates into a vapor. The vapor moves to the condenser section 22 where it cools and condenses. The liquid then moves back to the evaporator section 26 with the assistance of gravity. The cycle of evaporation and condensation transfers thermal energy from the evaporator section 26 to the condenser section 22 of the heat pipe 20. Fins 10 thermally coupled to the condenser section 22 assist to dissipate the heat from the condenser section 22. The heat pipes 20 may also include a wick which is formed on an interior of the heat pipe 20 to assist with moving the condensed liquid to the evaporator section 26. The wick may extend through the full length of the heat pipe 20 or through a portion of the heat pipe 20.

The condenser section 22 is inclined with respect to horizontal by an angle 27 so as to utilize gravity to assist in returning condensed liquid to the evaporator section 26. As noted elsewhere herein, the angle 27 may be, for example and without limitation, in a range of 5-40 degrees, and preferably within a range of 5-20 degrees.

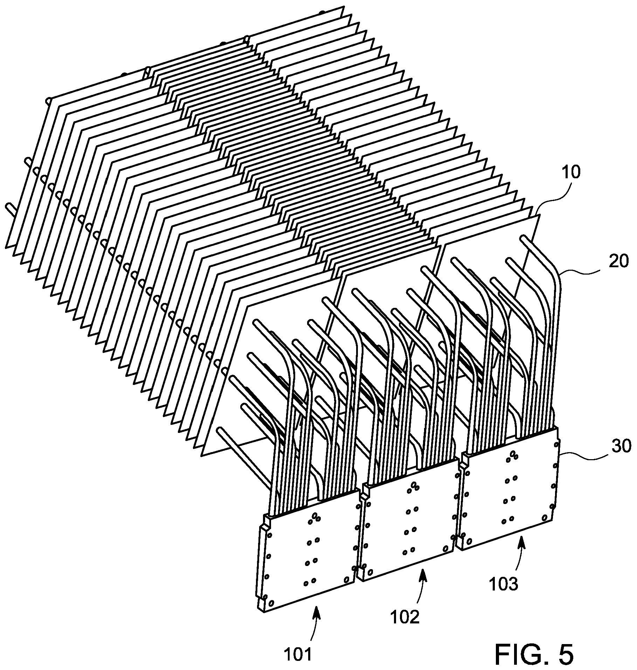

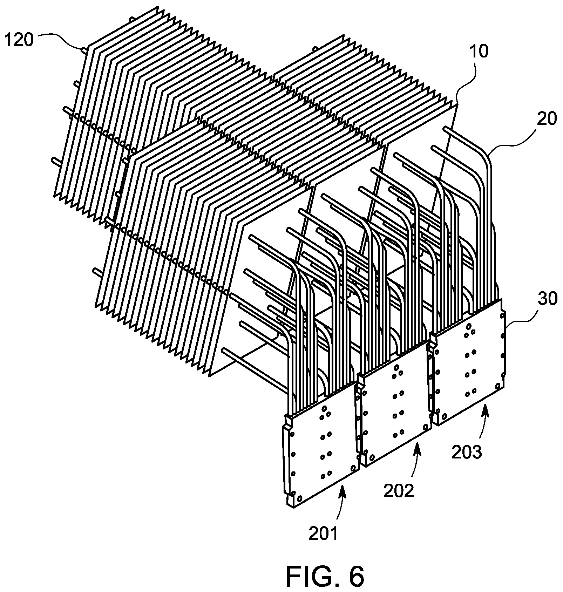

FIGS. 5 and 6 illustrate arrangements of heat sinks. Referring first to FIG. 5, a plurality of heat sinks 101, 102, and 103 are arranged together so as to dissipate heat from one or more heat sources. As illustrated in FIG. 5, heat sinks 101, 102, and 103 each include a cold plate 30, a plurality of heat pipes 20 attached to the cold plate 30, and a plurality of fins 10 attached to a condenser section of the heat pipes 20. The heat sinks 101, 102, and 103 are similar to the heat sink 5 shown in FIGS. 1-3. However, characteristics of the heat sinks 101, 102, and 103 are varied. For example, heat sinks 101 and 103 have similar characteristics, but heat sink 102 has a higher density of fins 10 (i.e. more fins per unit of length) thermally coupled to the condenser section of the heat pipes 20 than heat sinks 101 and 103, thus allowing heat sink 102 to dissipate a larger amount of heat than heat sinks 101 or 103.

Continuing to refer to FIG. 5, the heat sinks 101, 102, and 103 are arranged such that their respective cold plates 30 are coplanar and adjacent to each other. The coplanar arrangement allows multiple cold plates 30 to be easily thermally coupled to a heat source (such as a number of power semiconductors). Additionally, a thermally conductive member, such as, without limitation, a metal piece or a heat pipe, can be attached across the cold plates 30 of heat sinks 101, 102, and 103 so as to both attach the heat sinks 101, 102, and 103 to each other and to thermally couple the heat sinks 101, 102, and 103 to one or more heat sources.

Referring to FIG. 6, a plurality of heat sinks 201, 202, and 203 are arranged together so as to dissipate heat from one or more heat sources. In FIG. 6, heat sinks 201 and 203 are similar to each other and each include a cold plate 30, a plurality of heat pipes 20 thermally coupled with the cold plate 30, and a plurality of fins 10 thermally coupled with a condenser section of the heat pipes 20. Heat sink 202 is similar to heat sinks 201 and 203 except that heat sink 202 uses heat pipes 120 which have a longer condenser section than heat pipes 20. Additionally, heat sink 202 includes a larger number of fins 10 than heat sinks 201 and 203. The heat pipes 120 with a longer condenser section and larger number of fins 10 allow heat sink 202 to dissipate more heat than heat sinks 201 or 203.

While FIGS. 5 and 6 include multiple heat sinks arranged together while varying the density of fins coupled to the condenser section of the heat pipes or varying the length of the condenser section of the heat pipes and the number of fins coupled to the condenser section of the heat pipes, other characteristics of the heat sinks, such as, for example and without limitation, the number of heat pipes used in each heat sink or the size of each heat sink, the material used in the cold plate and/or fins, the working fluid(s) in the heat pipes, or the material used in the heat pipes can be varied while remaining within the scope of the invention.

Characteristics of each heat sink may be determined based on, for example and without limitation, expected thermal loading. For example, if it is anticipated that a heat source or arrangement of heat sources will provide a higher thermal load at a central area and a lower thermal load at an outer area, an arrangement of heat sinks which provides a higher heat dissipation to a central area, such as, for example, the arrangements shown in FIGS. 5 and 6, can be used. While the heat sinks of FIGS. 5 and 6 can dissipate a higher thermal load in a central area of a heat source or heat sources, heat sinks can be arranged with varying characteristics determined to dissipate various thermal loads while remaining within the scope of the invention.

FIG. 7 illustrates a system that does not form part of the present invention. The system includes a heat sink 5 including heat pipes 20, cold plate 30, and fins 10 which are similar to the heat sink 5 described above with respect to FIGS. 1-3. However, the arrangements of heat sinks shown in FIGS. 5-6 can also be adapted for use in the system shown in FIG. 7. The system additionally includes an enclosure 100, a blower 110, a thermally conductive adhesive 120, a circuit board 130, and a heat source 140.

As shown in FIG. 7, the evaporator section 26 of the heat pipes 20 is disposed primarily inside the enclosure 100 and the condenser section 22 of the heat pipes 20 is disposed primarily outside the enclosure 100. With this arrangement, the heat source 140, which is in close proximity with the evaporator section 26 of the heat pipes 20, may be shielded from the outside environment.

The blower 110 is adapted to blow air across the fins 10. Including the blower 110 increases the amount of heat dissipated by the fins 10 compared to a heat sink 5 which operates through only natural convection. In FIG. 7, the blower 110 is disposed below the fins 10. However, it is contemplated that the blower 110 may be disposed at any suitable location to blow air over the fins 10. Furthermore, it is contemplated that the blower 110 may be omitted.

In the system shown in FIG. 7, the heat source 140 is thermally coupled to the cold plate 30 with a thermally conductive adhesive 120. However, the heat source 140 may be coupled to the cold plate 30 in any suitable manner which thermally couples the heat source 140 and the cold plate 30.

The heat source 140 may be any type of device that generates heat, such as, without limitation, semiconductor devices which generate a large amount of heat.

The heat source 140 is a power semiconductor such as an insulated gate bipolar transistor (IGBT). However, it will be appreciated that the heat source 140 may be a variety of different semiconductor devices or other devices which generate heat.

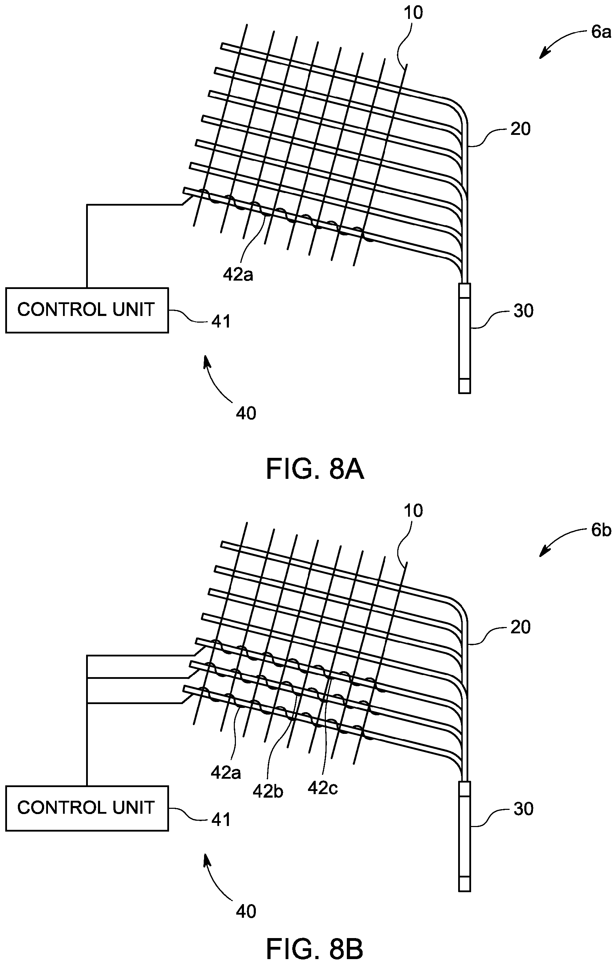

FIGS. 8A and 8B are side views of heat sinks 6a and 6b that do not form part of the present invention. The heat sink 6a illustrated in FIG. 8A includes fins 10, heat pipes 20, and a cold plate 30 arranged similar to the heat sink 5 described above with respect to FIG. 1. However, in FIG. 8A, the heat sink 6 further includes a heating unit 40.

The heating unit 40 includes a control unit 41 which is electrically connected to a first resistive element 42a. The first resistive element 42a is wrapped around the condenser section of the one of the heat pipes 20. The control unit 41 applies power to the first resistive element 42a so as to heat the first resistive element 42a, thus heating the condenser section of the heat pipe 20 that the first resistive element 42a is wrapped around. While FIG. 8A illustrates one resistive element 42a wrapped around the condenser section of one of the heat pipes 20, the heat sink 6b illustrated in FIG. 8B includes multiple resistive elements 42a, 42b, and 42c, each operatively coupled to the control unit 41. The multiple resistive elements 42a, 42b, and 42c are used to heat multiple heat pipes 20. It will be understood that any suitable number of resistive elements can be employed without departing from the scope of the disclosed concept. Additionally, when multiple resistive elements are used, the control unit 41 may further selectively apply power to a subset of the resistive elements so as to control the number of heat pipes 20 that are heated.

By heating the condenser sections of a subset of the heat pipes 20, the heating unit 40 can prevent the liquid used in the subset of heat pipes 20 from freezing in the condenser section, thus allowing the subset of heat pipes 20 to remain operable. Alternatively, the heating unit 40 can melt liquid that is already frozen in the condenser section. Additionally, the heating unit 40 can prevent a heat source coupled to the heat sink 6 from being exposed to too wide a range of temperatures (e.g. when the liquid in the heat pipes 20 is much colder than the temperature of the heat source). Furthermore, the heating unit 40 allows liquids which have a narrower range of operation (e.g. liquids which freeze at a higher temperature) to be used in the heat pipes 20.

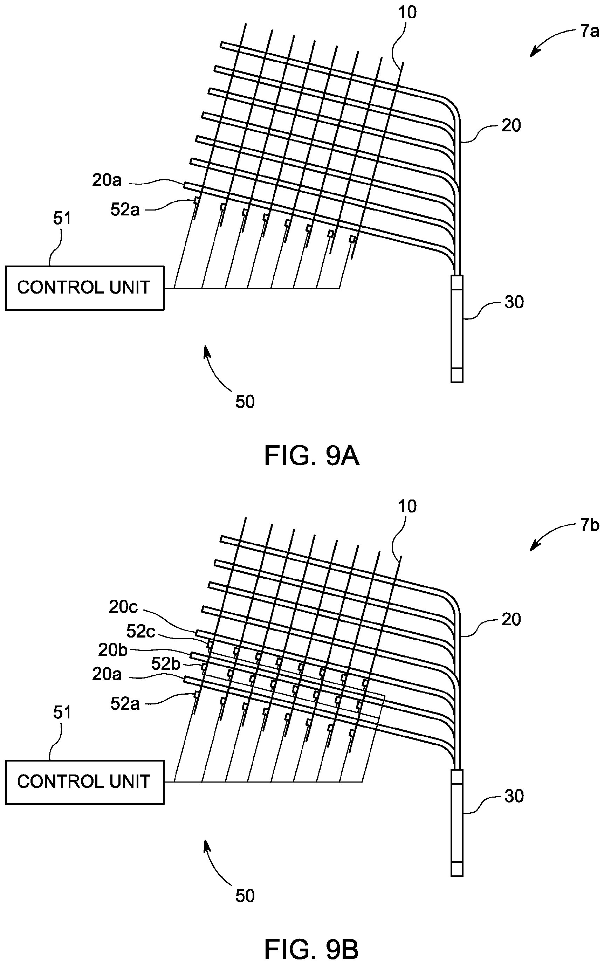

FIGS. 9A and 9B are side views of heat sinks 7a and 7b implemented according to the present invention. The heat sink 7a illustrated in FIG. 9A includes fins 10, heat pipes 20, and a cold plate 30 arranged similar to the heat sink 5 described above with respect to FIG. 1. However, in the exemplary embodiment illustrated in FIG. 9A, the heat sink 7a further includes a heating unit 50.

The heating unit 50 includes a control unit 51 which is electrically connected to one or more heaters 52a. The heaters 52a are each attached to one of the fins 10 nearby a respective heat pipe 20a. The control unit 51 applies power to selected heaters 52a so as to heat the selected heat pipe 20a. While FIG. 9A illustrates a plurality of heaters 52 disposed on the fins 10 in the vicinity of one of the heat pipes 20a, it will be understood that multiple sets of heaters may be used to heat multiple different heat pipes. For example, as illustrated in FIG. 9B, the heating unit 50 includes a first set of heaters 52a disposed nearby a first heat pipe 20a, a second set of heaters 52b disposed nearby a second heat pipe 52b, and a third set of heaters 52c disposed nearby a third heat pipe 20c. The control unit 41 may further selectively apply power to a subset of the heaters 52a, 52b, and/or 52c so as to control the number of heat pipes that are heated. In an exemplary embodiment, each of heaters 52a are closer to the respective heat pipe 20a than any other heat pipe. Each of the heaters 52a may also be located within a range of about 1-4 cm of the respective heat pipe 20a. However, the distance of the heaters 52a from the respective heat pipe 20a can be suitably changed based on, for example, changes in the scale of the heat sink.

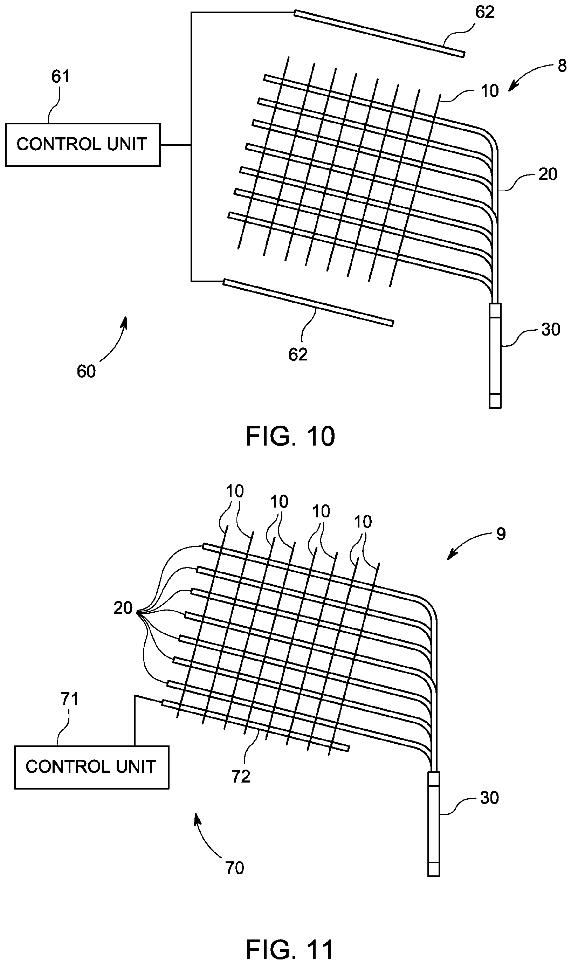

FIG. 10 is a side view of a heat sink 8 that does not form part of the present invention. The heat sink 8 illustrated in FIG. 10 includes fins 10, heat pipes 20, and a cold plate 30 arranged similar to the heat sink 5 described above with respect to FIG. 1. However, in FIG. 10, the heat sink 6 further includes a heating unit 60.

The heating unit 60 includes a control unit 61 which is electrically connected to radiant heaters 62. The control unit 61 applies power to the radiant heaters 62, thus causing the radiant heaters 62 to emit radiant energy. In addition, the condenser sections of a selected subset of the heat pipes 20 are colored with a dark color which is effective in absorbing radiant energy. The selected subset of heat pipes 20 absorbs radiant energy emitted from the radiant heaters 62, and are thus heated. While other heat pipes 20 also absorb radiant energy, the heat pipes 20 which are colored with the dark color are more effective at absorbing radiant energy, and thus the radiant heaters 62 do not require as much power to heat the heat pipes 20 colored with the dark color.

In FIG. 10, radiant heaters 62 are disposed above and below the fins 10. However, it will be understood that other suitable arrangements of radiant heaters can be used. For example, one or more radiant heaters 62 may be disposed only above or only below the fins 10.

FIG. 11 is a side view of a heat sink that does not form part of the present invention. The heat sink 9 illustrated in FIG. 11 includes fins 10, heat pipes 20, and a cold plate 30 arranged similar to the heat sink 5 described above with respect to FIG. 1. However, in FIG. 11, the heat sink 9 further includes a heating unit 70.

The heating unit 70 includes a control unit 71 which is electrically connected to a tubular heater 72. The tubular heater 72 can extend through the fins 10 similar to the condenser sections 22 of the plurality of heat pipes 20. The control unit 61 applies power to the tubular heater 72, thus causing the tubular heater 72 to heat nearby heat pipes 20. The tubular heater 72 is constructed from a hollow pipe with a heating element disposed therein.

In some embodiments, the control units 41, 51, 61, and 71 described above may apply power to the resistive element 42, heaters 52, radiant heaters 62, or tubular heater 72 based on at least one of a temperature of a heat source coupled to the cold plate 30, a temperature of the condenser sections of the plurality of heat pipes 20, and an ambient temperature. Additionally, the control units 41, 51, 61, and 71 may apply power to the resistive element 42, heaters 52, radiant heaters 62, or tubular heater 72 based on, for example, temperature data received from an external source (e.g., a temperature sensor located elsewhere in the apparatus, a weather station, etc.). The control units 41, 51, 61, and 71 may also apply power to the resistive element 42, heaters 52, radiant heaters 62, or tubular heater 72 based on any of a temperature of the fins 10, an air temperature at the top or bottom of the fins 10, and a temperature at the adiabatic section of the heat pipes 20. The control units 41, 51, 61, and 71 may be in communication with and receive outputs from one or more temperature sensors in order to monitor the aforementioned temperatures.

The control units 41, 51, 61, and 71 can control the power that is applied to resistive element 42, heaters 52, radiant heaters 62, or tubular heater 72 in any suitable manner. For example, control units 41,51,61, and 71 can control not only which one of the resistive elements 42, heaters 52, radiant heaters 62, or tubular heater 72 to apply power to, but how much power to apply and how long to apply the power. Additionally, controls units 41,51,61, and 71 can also sequence the application of power across multiple ones of the resistive elements 42, heaters 52, radiant heaters 62, or tubular heater 72.

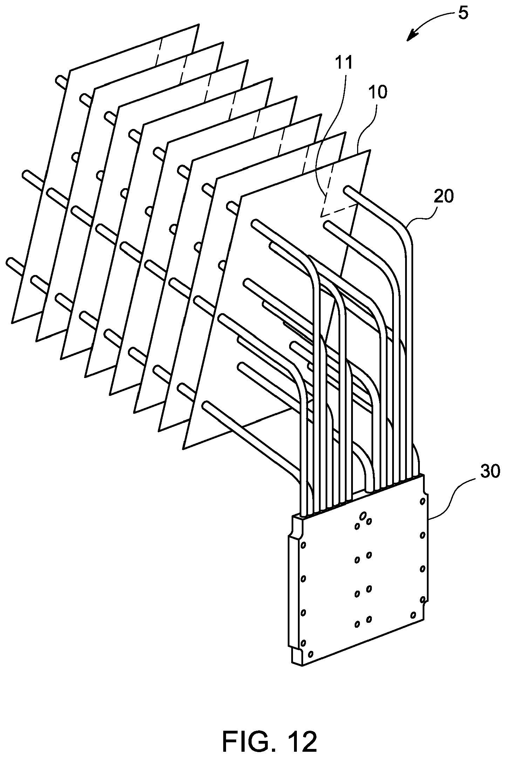

The fins 10 may also be structured such that the fins do not dissipate heat from a selected subset of heat pipes. For example and without limitation, the fins 10 can be structured so that they are not thermally coupled with a selected subset of heat pipes 20. Referring to FIG. 12, the fins 10 may include perforations 11 structured such that the fins 10 do not effectively dissipate heat from a selected subset of heat pipes 20. In the example shown in FIG. 12, the perforations 11 prevent the fins 10 from effectively dissipating the heat from one of the heat pipes 20. However, the perforations 11 can be structured to prevent the fins 10 from effectively dissipating the heat of multiple heat pipes 20 without departing from the scope of the disclosed concept. When the fins 10 do not effectively dissipate heat from a selected subset of heat pipes 20, the selected subset of heat pipes 20 will operate at a higher temperature, and thus will not freeze as quickly as other heat pipes 20. As such, the heat sink can remain operational at a lower temperature. The same effect can be accomplished by installing separate fins or fin stacks rather than perforating the fins 10.

It is appreciated that the heat sinks 6, 7, 8, and 9, illustrated in FIGS. 8, 9, 10, and 11, can be readily adapted for use in the system illustrated in FIG. 7 or adapted for use in the heat sink 1 illustrated in FIG. 1. It is also appreciated that features of the above-described embodiments may be used in combination with each other. For example and without limitation, it is contemplated that a heat sink may incorporate both the heating unit 50 illustrated in FIG. 9 and the heating unit 60 illustrated in FIG. 10, or any other combination of features.

In the claims, any reference signs placed between parentheses shall not be construed as limiting the claim. The word "comprising" or "including" does not exclude the presence of elements or steps other than those listed in a claim. In a device claim enumerating several means, several of these means may be embodied by one and the same item of hardware. The word "a" or "an" preceding an element does not exclude the presence of a plurality of such elements. In any device claim enumerating several means, several of these means may be embodied by one and the same item of hardware. The mere fact that certain elements are recited in mutually different dependent claims does not indicate that these elements cannot be used in combination. mere fact that certain elements are recited in mutually different dependent claims does not indicate that these elements cannot be used in combination.

Although the invention has been described in detail for the purpose of illustration based on what is currently considered to be the most practical and preferred embodiments, it is to be understood that such detail is solely for that purpose and that the invention is not limited to the disclosed embodiments, but, on the contrary, is intended to cover modifications and equivalent arrangements that are within the spirit and scope of the appended claims. For example, it is to be understood that the present invention contemplates that, to the extent possible, one or more features of any embodiment can be combined with one or more features of any other embodiment.

## Claims

1. A heat sink (7a; 7b), comprising:
a cold plate (30) having a first surface adapted to thermally couple to a heat source;
a plurality of heat pipes (20), each of the heat pipes having an evaporator section (26) thermally coupled to the cold plate (30) and a condenser section (22) coupled to the evaporator section (26);
a plurality of fins (10) thermally coupled to the condenser sections (22) of the plurality of heat pipes (20);
a heating unit (50) adapted to heat condenser sections (22) of only a subset of the plurality of heat pipes (20) and including a plurality of heating devices (52a); and
a control unit (51) electrically connected to the plurality of heating devices (52a) and adapted to selectively provide power to the heating devices (52a) to heat the heating devices (52a) to thereby heat the subset of the plurality of heat pipes (20);
**characterized in that** each of the plurality of heating devices (52a) is attached to a respective one of the fins (10) nearby one of the heat pipes (20a) of the subset of the plurality of heat pipes (20).

2. A heat sink (7a; 7b) according to claim 1, wherein the heating unit (50) further comprises:
a plurality of second heating devices (52b), wherein each of the plurality of second heating devices (52b) is attached to a respective one of the fins (10) nearby a second one of the heat pipes (20b) of the subset of the plurality of heat pipes (20).

3. A heat sink (7a; 7b) according to claim 1 or claim 2, further comprising:
at least one temperature sensor adapted to sense at least one of a temperature of the heat source, a temperature of the condenser sections (22) of the plurality of heat pipes (20), and an ambient temperature, wherein the control unit (51) controls the heating unit (50) to heat the subset of the plurality of heat pipes (20) based on at least one of the temperature of the heat source, the temperature of the condenser sections of the plurality of heat pipes, and the ambient temperature.

4. A heat sink (7a; 7b) according to any preceding claim, wherein the control unit (51) determines an amount of heat to apply to the subset of the plurality of heat pipes (20) and controls the amount of heat by controlling at least one of a number of heat pipes heat is applied to, a duration in which power is applied, and an amount of power which is applied.

5. A heat sink (7a; 7b) according to any preceding claim, wherein the plurality of fins (10) each include at least one perforation (11) which reduces an amount the plurality of fins dissipates heat of a selected one or more of the heat pipes of the plurality of heat pipes (20) with respect to the remaining heat pipes of the plurality of heat pipes (20).

6. A method of heating heat pipes (20), the method comprising:
providing a cold plate (30) having a first surface adapted to thermally couple to a heat source;
providing a plurality of heat pipes (20), each of the heat pipes having an evaporator section (26) thermally coupled to the cold plate (30) and a condenser section (22) coupled to the evaporator section (26);
providing a plurality of fins (10) thermally coupled to the condenser sections (22) of the plurality of heat pipes (20);
providing a plurality of heating devices (52a); and
providing power to the heating devices (52a) to heat the heating devices (52a) thereby heating condenser sections (22) of only a subset of the plurality of heat pipes (20);
**characterized in that** each of the plurality of heating devices (52a) is attached to a respective one of the fins (10) nearby one of the heat pipes (20a) of the subset of the plurality of heat pipes (20).

## Patentansprüche

1. Wärmesenke (7a; 7b), die aufweist:
eine Kälteplatte (30), die eine erste Oberfläche aufweist, die eingerichtet ist, um mit einer Wärmequelle thermisch gekoppelt zu sein;
mehrere Wärmerohre (20), wobei jedes der Wärmerohre einen Verdampferabschnitt, der mit der Kälteplatte (30) thermisch gekoppelt ist, und einen Kondensatorabschnitt (22) aufweist, der mit dem Verdampferabschnitt (26) gekoppelt ist;
mehrere Lamellen (10), die mit den Kondensatorabschnitten (22) der mehreren Wärmerohre (20) thermisch gekoppelt sind;
eine Heizeinheit (50), die eingerichtet ist, um die Kondensatorabschnitte (22) von lediglich einer Teilmenge der mehreren Wärmerohre (20) zu erwärmen und mehrere Heizvorrichtungen (52a) enthält; und
eine Steuereinheit (51), die mit den mehreren Heizvorrichtungen (52a) elektrisch verbunden und eingerichtet ist, um wahlweise Strom zu den Heizvorrichtungen (52a) zu liefern, um die Heizvorrichtungen (52a) zu erwärmen, um dadurch die Teilmenge der mehreren Wärmerohre (20) zu erwärmen;
**dadurch gekennzeichnet, dass** jede der mehreren Heizvorrichtungen (52a) an einer jeweiligen einzelnen der Lamellen (10) nahe an einem einzelnen der Wärmerohre (20a) der Teilmenge der mehreren Wärmerohre (20) angebracht ist.

2. Wärmesenke (7a; 7b) nach Anspruch 1, wobei die Heizeinheit (50) ferner aufweist:
mehrere zweite Heizvorrichtungen (52b), wobei jede der mehreren zweiten Heizvorrichtungen (52b) an einer jeweiligen einzelnen der Lamellen (10) nahe an einem zweiten einzelnen der Wärmerohre (20b) der Teilmenge der mehreren Wärmerohre (20) angebracht ist.

3. Wärmesenke (7a; 7b) nach Anspruch 1 oder Anspruch 2, die ferner aufweist:
wenigstens einen Temperatursensor, der eingerichtet ist, um wenigstens eine von einer Temperatur der Wärmequelle, einer Temperatur der Kondensatorabschnitte (22) der mehreren Wärmerohre (20) und einer Umgebungstemperatur zu erfassen, wobei die Steuereinheit (51) die Heizeinheit (50) steuert, um die Teilmenge der mehreren Wärmerohre (20) basierend auf wenigstens einer von der Temperatur der Wärmequelle, der Temperatur der Kondensatorabschnitte der mehreren Wärmerohre und der Umgebungstemperatur zu erwärmen.

4. Wärmesenke (7a; 7b) nach einem beliebigen vorhergehenden Anspruch, wobei die Steuereinheit (51) eine Wärmemenge bestimmt, die der Teilmenge der mehreren Wärmerohre (20) zuzuführen ist, und die Wärmemenge steuert, indem sie wenigstens eine von einer Anzahl von Wärmerohren, denen Wärme zugeführt wird, einer Dauer, in der Strom angelegt wird, und einer Strommenge, die angelegt wird, steuert.

5. Wärmesenke (7a; 7b) nach einem beliebigen vorhergehenden Anspruch, wobei die mehreren Lamellen (10) jeweils wenigstens eine Perforierung (11) enthalten, die eine Menge reduziert, die die mehreren Lamellen an Wärme aus einem ausgewählten einzelnen oder mehreren der Wärmerohre der mehreren Wärmerohre (20) in Bezug auf die restlichen Wärmerohre der mehreren Wärmerohre (20) abführen.

6. Verfahren zum Erwärmen von Wärmerohren (20), wobei das Verfahren aufweist:
Bereitstellen einer Kälteplatte (30), die eine erste Oberfläche aufweist, die eingerichtet ist, um mit einer Wärmequelle thermisch gekoppelt zu sein;
Bereitstellen mehrerer Wärmerohre (20), wobei jedes der Wärmerohre einen Verdampferabschnitt (26), der mit der Kälteplatte (30) thermisch gekoppelt ist, und einen Kondensatorabschnitt (22) aufweist, der mit dem Verdampferabschnitt (26) gekoppelt ist;
Bereitstellen mehrerer Lamellen (10), die mit den Kondensatorabschnitten (22) der mehreren Wärmerohre (20) thermisch gekoppelt sind;
Bereitstellen mehrerer Heizvorrichtungen (52a); und
Liefern von Strom zu den Heizvorrichtungen (52a), um die Heizvorrichtungen (52a) zu erwärmen, wodurch Kondensatorabschnitte (22) von lediglich einer Teilmenge der mehreren Wärmerohre (20) erwärmt werden;
**dadurch gekennzeichnet, dass** jede der mehreren Heizvorrichtungen (52a) an einer jeweiligen einzelnen der Lamellen (10) nahe an einem einzelnen der Wärmerohre (20a) der Teilmenge der mehreren Wärmerohre (20) angebracht ist.

## Revendications

1. Dissipateur thermique (7a ; 7b) comprenant :
une plaque froide (30) comportant une première surface adaptée pour s'accoupler thermiquement à une source de chaleur ;
une pluralité de caloducs (20), chacun des caloducs ayant une section d'évaporateur (26) accouplée thermiquement à la plaque froide (30) et une section de condenseur (22) accouplée à la section d'évaporateur (26) ;
une pluralité d'ailettes (10) accouplées thermiquement aux sections de condenseur (22) de la pluralité de caloducs (20) ;
une unité de chauffage (50) adaptée pour chauffer les sections de condenseur (22) uniquement d'un sous-ensemble de la pluralité de caloducs (20) et comprenant une pluralité de dispositifs chauffants (52a) ; et
une unité de commande (51) connectée électriquement à la pluralité de dispositifs chauffants (52a) et adaptée pour fournir sélectivement de l'énergie aux dispositifs chauffants (52a) pour chauffer les dispositifs chauffants (52a) afin de chauffer le sous-ensemble de la pluralité de caloducs (20) ;
**caractérisé en ce que** chacun des dispositifs chauffants (52a) est fixé sur une ailette respective parmi lesdites ailettes (10) à proximité de l'un des caloducs (20a) du sous-ensemble de la pluralité de caloducs (20).

2. Dissipateur thermique (7a ; 7b) selon la revendication 1, dans lequel l'unité de chauffage (50) comprend en outre :
une pluralité de deuxièmes dispositifs chauffants (52b), chacun des deuxièmes dispositifs chauffants (52b) étant fixé à une ailette respective parmi lesdites ailettes (10) à proximité d'un deuxième des caloducs (20b) du sous-ensemble de la pluralité de caloducs (20).

3. Dissipateur thermique (7a ; 7b) selon la revendication 1 ou 2, comprenant en outre :
au moins un capteur de température adapté pour mesurer au moins un paramètre parmi une température de la source de chaleur, une température des sections de condenseur (22) de la pluralité de caloducs (20) et une température ambiante, dans lequel l'unité de commande (51) commande l'unité de chauffage (50) pour chauffer le sous-ensemble de la pluralité de caloducs (20) en se basant sur au moins un paramètre parmi la température de la source de chaleur, la température des sections de condenseur de la pluralité de caloducs et la température ambiante.

4. Dissipateur thermique (7a ; 7b) selon l'une quelconque des revendications précédentes, dans lequel l'unité de commande (51) détermine une quantité de chaleur à appliquer au sous-ensemble de la pluralité de caloducs (20) et commande la quantité de chaleur en commandant au moins un paramètre parmi un nombre de caloducs auxquels on applique de la chaleur, une durée pendant laquelle l'énergie est appliquée, et une quantité d'énergie qui est appliquée.

5. Dissipateur thermique (7a ; 7b) selon l'une quelconque des revendications précédentes, dans lequel les ailettes (10) comprennent toutes au moins une perforation (11) qui réduit une quantité de chaleur dissipée par la pluralité d'ailettes d'un ou de plusieurs des caloducs de la pluralité de caloducs (20) par rapport aux caloducs restants de la pluralité de caloducs (20).

6. Procédé de chauffage de caloducs (20), le procédé comprenant les étapes suivantes :
fournir une plaque froide (30) comportant une première surface adaptée pour s'accoupler thermiquement à une source de chaleur ;
fournir une pluralité de caloducs (20), chacun des caloducs ayant une section d'évaporateur (26) accouplée thermiquement à la plaque froide (30) et une section de condenseur (22) accouplée à la section d'évaporateur (26) ;
fournir une pluralité d'ailettes (10) accouplées thermiquement aux sections de condenseur (22) de la pluralité de caloducs (20) ;
fournir une pluralité de dispositifs chauffants (52a) ; et
fournir de l'énergie aux dispositifs chauffants (52a) pour chauffer les dispositifs chauffants (52a) afin de chauffer les sections de condenseur (22) uniquement d'un sous-ensemble de la pluralité de caloducs (20) ;
**caractérisé en ce que** chacun des dispositifs chauffants (52a) est fixé sur une ailette respective parmi lesdites ailettes (10) à proximité de l'un des caloducs (20a) du sous-ensemble de la pluralité de caloducs (20).
